# EUROPEAN PATENT APPLICATION

(11) **EP 1 498 778 A1**
(43) Date of publication of application: **19.01.2005**
(21) Application number: 03254078.3
(22) Date of filing: 27.06.2003
(51) Int. Cl.: G03F 7/20

(54) **Lithographic apparatus and device manufacturing method**

(71) Applicant: ASML Netherlands B.V., 5504 DR Veldhoven (NL)
(72) Inventor: The designation of the inventor has not yet been filed
(74) Representative: Leeming, John Gerard

(57) **Abstract**

A lithographic projection apparatus wherein a liquid supply system provides a space 2 between a final element of a projection system PL and a substrate W with liquid. The liquid supply system comprises a seal member 4. A liquid seal is formed by the flow of liquid from an inlet 6 to an outlet 8 of the seal member.

## Description

The present invention relates to a lithographic projection apparatus comprising:
- a radiation system for supplying a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate; and
- a liquid supply system for providing a space between a final element of said projection system and said substrate with a liquid.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection ( in the case of reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required.
- A programmable LCD array. An example of such a construction is given in United States Patent US 5,229,872, which is incorporated herein by reference. As above, the support structure in this case may be embodied as a frame or table, for example, which may be fixed or movable as required.
For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus -commonly referred to as a step-and-scan apparatus - each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, incorporated herein by reference.

It has been proposed to immerse the substrate in a lithographic projection apparatus in a liquid having a relatively high refractive index, e.g. water, so as to fill a space between the final element of the projection system and the substrate. The point of this is to enable imaging of smaller features since the exposure radiation will have a shorter wavelength in the liquid. (The effect of the liquid may also be regarded as increasing the effective NA of the system and also increasing the depth of focus.)

However, submersing the substrate or substrate and substrate table in a bath of liquid (see for example US 4,509,852, hereby incorporated in its entirety by reference) means that there is a large body of liquid that must be accelerated during a scanning exposure. This requires additional or more powerful motors and turbulence in the liquid may lead to undesirable and unpredictable effects.

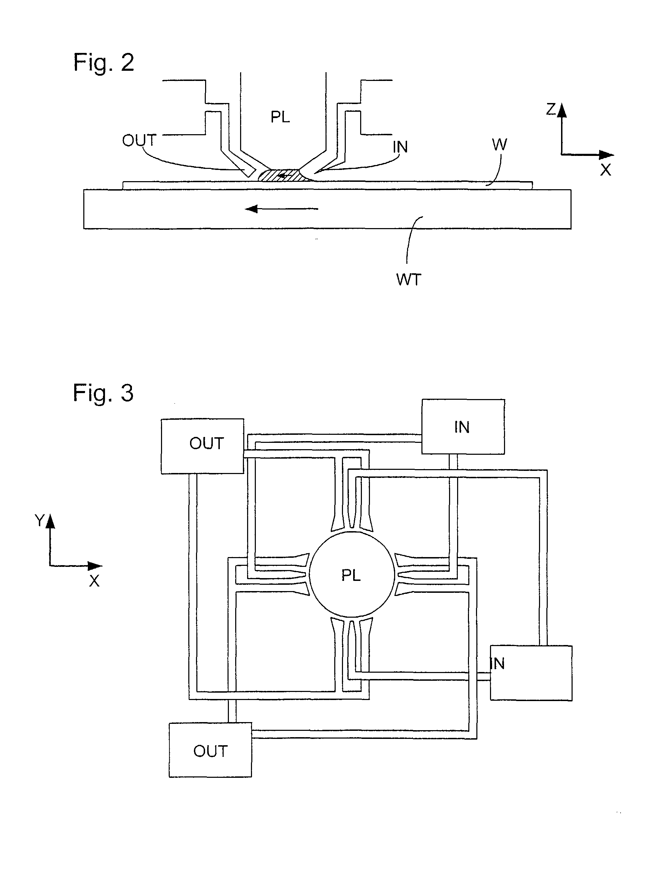

One of the solutions proposed is for a liquid supply system to provide liquid on a localized area of the substrate and in between the final element of the projection system and the substrate (the substrate generally has a larger surface area than the final element of the projection system). One way which has been proposed to arrange for this is disclosed in WO 99/49504, hereby incorporated in its entirety by reference. As illustrated in Figures 2 and 3, liquid is supplied by at least one inlet IN onto the substrate, preferably along the direction of movement of the substrate relative to the final element, and is removed by at least one outlet OUT after having passed under the projection system. That is, as the substrate is scanned beneath the element in a -X direction, liquid is supplied at the +X side of the element and taken up at the -X side. Figure 2 shows the arrangement schematically in which liquid is supplied via inlet IN and is taken up on the other side of the element by outlet OUT which is connected to a low pressure source. In the illustration of Figure 2 the liquid is supplied along the direction of movement of the substrate relative to the final element, though this does not need to be the case. Various orientations and numbers of in-and out-lets positioned around the final element are possible, one example is illustrated in Figure 3 in which four sets of an inlet with an outlet on either side are provided in a regular pattern around the final element.

Another solution which has been proposed is to provide the liquid supply system with a seal member which extends along at least a part of a boundary of the space between the final element of the projection system and the substrate table. The seal member is substantially stationary relative to the projection system in the XY plane and a seal is formed between the seal member and the surface of the substrate. Previously, a contactless seal such as a gas seal has been proposed. More information on gas seals can be gleaned from, for example, European Patent Application Number 03252955.4 incorporated herein by reference.

However, while a gas seal seals the liquid effectively it can present further problems. A relatively high gas pressure is required (with overpressure or gauge pressure relative to the environment of 1000-10000 Pa) and this combined with the relatively low damping of a gas seal means that vibrations can be transmitted through the gas seal causing an adverse effect on the performance of the imaging system. The vibrations due to pressure disturbances can cause servo errors of between 1 to 50 nm.

It is an object of the present invention to provide an effective seal to contain the liquid in a space between the final element of the projection system and the surface of a substrate being imaged.

This and other objects are achieved according to the invention in a lithographic apparatus as specified in the opening paragraph, characterized in that said liquid supply system comprises:
- a seal member extending along at least part of the boundary of said space between the final element of said projection system and said substrate; and
- a liquid seal means for forming a liquid seal between said seal member and the surface of the substrate.

This construction has the advantage that no gas supply is required. Therefore, no bubbles can form in the liquid because of the gas supply. The liquid seal is operative to retain the liquid in the space and also to prevent the inclusion of gas from the environment of the apparatus which surrounds the substrate table. The liquid also has good damping characteristics, which reduces the transmission of disturbances through the seal. Additionally, the construction of the seal is simplified because there is no need to provide a gas inlet to the seal as there is with a gas seal. Furthermore, a liquid seal can be effective with a smaller volume and/or a greater gap height than a corresponding gas seal.

Optionally, said liquid seal means is either a hydrostatic or hydrodynamic bearing for supporting said seal member above the surface of said substrate. The provision of a hydrostatic or hydrodynamic bearing for both support and sealing allows the seal to function over a larger gap range, for example up to 1mm, preferably in the range 10 to 300 µm. The bearing has stiffness and damping in 3 degrees of freedom: in the vertical (z) direction, and rotation about axes perpendicular to the z direction. It will therefore also function as suspension for the seal member.

Optionally, the pressure of the liquid in said hydrostatic bearing is in the range of 100 Pa to 100 kPa relative to the ambient pressure. Ambient pressure refers to pressure in the apparatus surrounding the liquid filled space. If the bearing pressure is in this range, the bearing will function as suspension for the seal member and transmit fewer vibrations than a comparable gas seal.

Optionally, said seal member further comprises a shared liquid outlet for removing liquid from said space and from said liquid seal means. By providing a shared liquid outlet for both the liquid seal means and the liquid filled space, the construction is further simplified.

Optionally, said shared outlet is located on a surface of said seal member which faces said substrate and is positioned between said space and said liquid seal means. The liquid in the seal will generally be at a higher pressure than the liquid in the space and therefore this pressure gradient will ensure that liquid supplied to the seal moves radially inwards towards the optical axis, improving the effectiveness of the seal.

Optionally, said shared liquid outlet has a cross sectional area in a plane substantially parallel to said substrate which is greater than the cross sectional area of a liquid inlet. The greater cross-sectional area allows the flow in the outlet to be laminar. This reduces turbulence in the liquid filling the space which can have an adverse and chaotic effect on accuracy.

According to a second aspect of the present invention, there is provided a lithographic projection apparatus comprising:
- a radiation system for providing a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate; and
- a liquid supply system for providing a space between the final element of said projection system and said substrate with a liquid,
characterized in that said liquid supply system comprises:
- a seal member extending along at least part of the boundary of said space between the final element of said projection system and said substrate
wherein said seal member comprises a liquid inlet located on a surface of said seal member which faces said substrate.

The positioning of the liquid inlet allows liquid to flow in an inward radial direction towards the liquid filled space. This reduces the flow of liquid in an outward radial direction and provides a more effective seal.

Optionally, the height of said seal member above the surface of said substrate is greater in the region between said space and said liquid inlet than elsewhere. By varying the height in this way the pressure of liquid supplied is reduced for the same rate of refreshment of liquid in the space. This reduces the transmission of unwanted vibrations. It also reduces the flow of liquid in an outward radial direction. This is beneficial because liquid flowing in this direction must be removed and removing a large amount can induce unwanted vibrations in the apparatus.

Optionally, said liquid supply system further comprises a gas seal means positioned outwards in a radial direction from said liquid inlet, for forming a gas seal between said seal member and the surface of said substrate.

Optionally, said seal member further comprises an intermediate gas inlet and a liquid outlet respectively positioned outwards in a radial direction from said liquid inlet and both located on said surface of said seal member which faces said substrate. The liquid outlet removes liquid which might otherwise leak in an outward radial direction. The intermediate gas inlet enhances the removal of the liquid at the liquid outlet.

Optionally, the height of said seal member above the surface of said substrate is greater between said intermediate gas inlet and said liquid outlet than between said liquid inlet and said intermediate gas inlet. This further improves the removal of liquid at the liquid outlet.

Optionally, in the above first or second aspect, said liquid supply system further comprises a low pressure source for preventing leakage of liquid in an outward radial direction, said low pressure source located on a surface of said seal member which faces said substrate. A low pressure source removes any liquid which leaks from the seal and stops it encroaching into the rest of the apparatus.

Optionally, the apparatus of the above first or second aspect further comprises means for applying a biasing force directed towards the surface of said substrate to said seal member. By applying a bias force on the seal member towards the substrate the force required to support the seal member can be adjusted as desired. If the liquid seal is a hydrostatic bearing, this allows the steady state operating pressure of the bearing to be adjusted without adjusting the dimensions of the bearing.

Optionally, the apparatus of the above first or second aspect further comprises a member connected between said seal member and a machine frame for supporting said seal member. This allows the position of the sealing member to be maintained in the correct position relative to the lens and can also provide support and suspension for the sealing member.

Optionally, in the apparatus of the above first or second aspects, said seal member comprises at least one liquid inlet, at least one liquid outlet and at least one combined outlet for both liquid and gas.

Optionally, in the apparatus of the above first or second aspects, said liquid supply system supplies liquid to said space at a rate of 0.1 to 10 liters per minute.

Optionally, in the apparatus of the above first or second aspects, said liquid supply system supplies liquid to said space at a pressure which compensates for liquid transported away from said space by relative movement between said substrate and said seal member. This allows the inclusion of gas into the liquid because of relative movement between the substrate and the seal member to be avoided.

Optionally, the apparatus of the above first or second aspects further comprises at least one chamber formed upstream of an inlet and/or downstream of an outlet of said seal member. This allows an even, homogenous flow of liquid and/or gas to be achieved.

Optionally, the apparatus of the above first or second aspects further comprises:
- at least one sensor to establish a distance between the surface of said substrate and said seal member; and
- a control system to control at least one actuator to maintain a desired distance between the surface of said substrate and said seal member based on the distance established by said sensor.
This allows the height of the seal member above the surface of the substrate to controlled with preferably 3 degrees of freedom.

Optionally, in the apparatus of the above first or second aspects, at least one inlet and/or outlet in said member has rounded edges. By rounded it is meant that the edge is not square, rounded accordingly includes arcuate and curved profiles. The degree of curvature depends on the dimensions of the inlet/outlet. The radius of curvature is preferably in the range 1 µm to 1mm. This improves the flow around the edge and reduces turbulence.

Optionally, in the apparatus of the above first or second aspects, at least one edge of said seal member adjacent to the surface of said substrate is rounded. By rounded it is meant that the edge is not square, rounded accordingly includes arcuate and curved profiles. The radius of curvature is preferably in the range 1 µm to 1mm.

According to a third aspect of the present invention there is provided a device manufacturing method comprising the steps of:
- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material using a projection system;
- providing a space between a final element of said projection system and said substrate with a liquid,
characterized by forming a liquid seal between the surface of said substrate and a seal member.

According to a fourth aspect of the present invention there is provided a device manufacturing method comprising the steps of:
- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material using a projection system;
- providing a space between a final element of said projection system and said substrate with a liquid,
characterized by supplying the liquid via a liquid inlet provided on a seal member, said liquid inlet facing the surface of said substrate.

Preferably the methods of the above third or fourth aspects further comprise the steps of:
- establishing the distance between the surface of said substrate and said seal member; and
- controlling at least one actuator to maintain a desired distance between the surface of said substrate and said seal member based on the established distance.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (*e.g*. with a wavelength of 365, 248, 193, 157 or 126 nm)

Embodiments of the invention will now be described, by way of example only, with reference to the accompanying schematic drawings in which:
Figure 1 depicts a lithographic projection apparatus according to an embodiment of the invention;
Figure 2 depicts a cross section of a liquid supply system which provides liquid in a localized area;
Figure 3 is a plan view of the liquid supply system of Figure 2;
Figure 4 depicts a cross section of a liquid supply system according to a first embodiment of the invention;
Figure 5 depicts a cross section of a liquid supply system according to a second embodiment of the invention;
Figure 6 depicts a cross section of a seal member according to a third embodiment of the present invention;
Figure 7 depicts a cross section of a liquid supply system according to a fourth embodiment of the present invention; and
Figure 8 depicts a cross section of a liquid supply system according to a fifth embodiment of the present invention.

In the Figures, corresponding reference symbols indicate corresponding parts.

### Embodiment 1

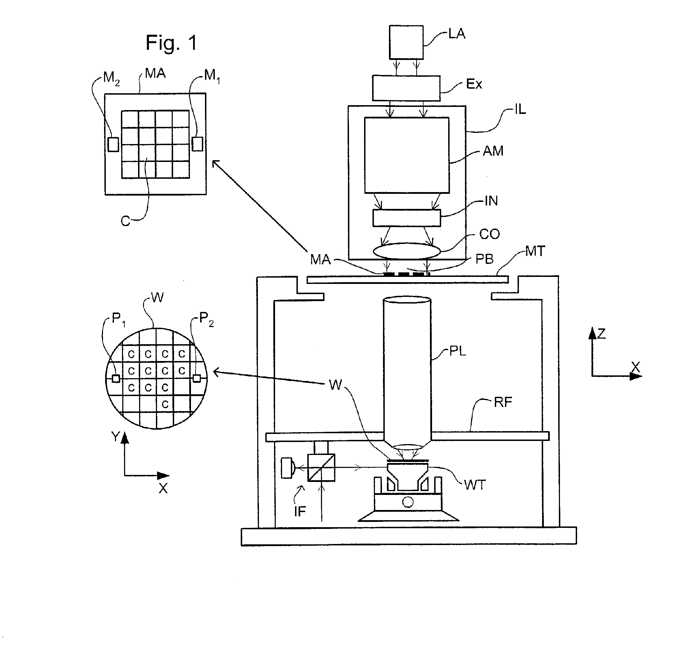

Figure 1 schematically depicts a lithographic projection apparatus according to a particular embodiment of the invention. The apparatus comprises:
· a radiation system Ex, IL, for supplying a projection beam PB of radiation (*e*.*g*. UV radiation), which in this particular case also comprises a radiation source LA;
· a first object table (mask table) MT provided with a mask holder for holding a mask MA (*e.g.* a reticle), and connected to first positioning means for accurately positioning the mask with respect to item PL;
· a second object table (substrate table) WT provided with a substrate holder for holding a substrate W (*e.g.* a resist-coated silicon wafer), and connected to second positioning means for accurately positioning the substrate with respect to item PL;
· a projection system ("lens") PL (*e.g*. a refractive lens system) for imaging an irradiated portion of the mask MA onto a target portion C (*e.g*. comprising one or more dies) of the substrate W.
As here depicted, the apparatus is of a transmissive type (*e.g*. has a transmissive mask). However, in general, it may also be of a reflective type, for example (*e*.*g*. with a reflective mask). Alternatively, the apparatus may employ another kind of patterning means, such as a programmable mirror array of a type as referred to above.

The source LA (*e.g.* an Hg lamp) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, *e*.*g*. after mechanical retrieval of the mask MA from a mask library, or during a scan. In general, movement of the object tables MT, WT will be realized with the aid of a long-stroke module (coarse positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:
1. In step mode, the mask table MT is kept essentially stationary, and an entire mask image is projected in one go (*i.e*. a single "flash") onto a target portion C. The substrate table WT is then shifted in the x and/or y directions so that a different target portion C can be irradiated by the beam PB;
2. In scan mode, essentiallythe same scenario applies, except that a given target portion C is not exposed in a single "flash". Instead, the mask table MT is movable in a given direction (the so-called "scan direction", *e.g*. the y direction) with a speed v, so that the projection beam PB is caused to scan over a mask image; concurrently, the substrate table WT is simultaneously moved in the same or opposite direction at a speed *V = Mv,* in which *M* is the magnification of the lens PL (typically, *M* = 1/4 or 1/5). In this marmer, a relatively large target portion C can be exposed, without having to compromise on resolution.

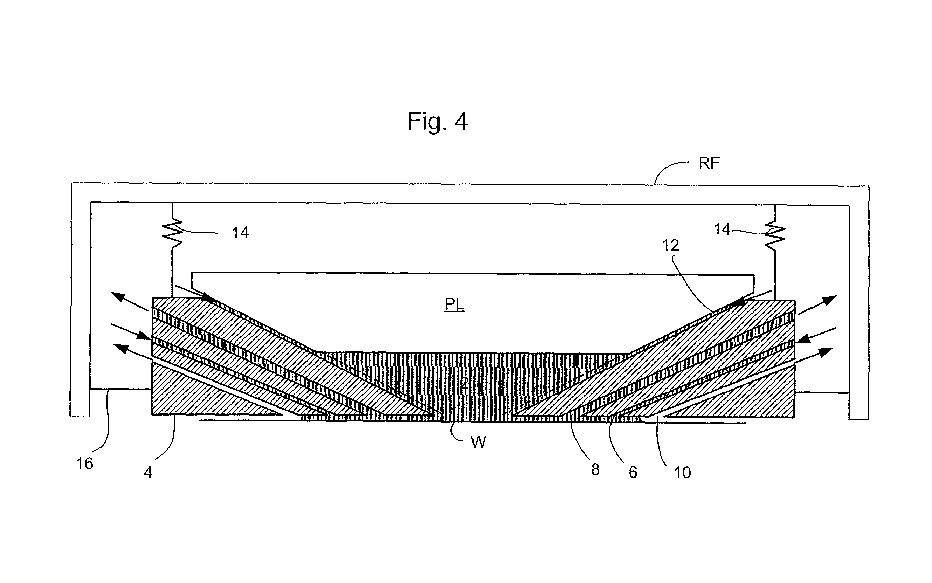

Figure 4 illustrates a liquid supply system according to the first embodiment of the present invention. A liquid fills a space 2 between a final element of the projection system PL and the substrate W. A seal member 4 is arranged between the final element of the projection system PL and the surface of the substrate W to define the space 2. A liquid seal is formed between the seal member 4 and the surface of the substrate W to prevent leakage of liquid from the space 2.

The seal member 4 has a liquid inlet 6 and a liquid outlet 8 in its surface which faces the substrate (hereinafter referred to as the primary surface). The outlet 8 is located radially inward of the inlet 6 with respect to the optical axis of the projection system. A liquid seal is formed by the flow of liquid from the inlet 6 to an outlet 8. Preferably the liquid seal is formed by a hydrostatic bearing defined by the flow of liquid from the inlet 6 to the outlet 8. This hydrostatic bearing can then support the seal member 4 as well as providing a liquid seal to prevent leakage of the liquid from the space 2.

A vacuum outlet 10 is also formed in the primary surface of the seal member 4, outwards in a radial direction from the inlet 6 with respect to the optical axis, for extracting any liquid which may escape from the seal into the area of the substrate W not immersed in liquid.

An additional liquid inlet 12 is formed in the gap between the final element of the projection system PL and the upper surface of the seal member 4. This additional inlet 12 is used to supply liquid into the space 2. In this embodiment the liquid is primarily distilled water, although other liquids can also be used.

Figure 4 depicts the seal member in cross section. It will be appreciated that the inlets 6 and 12 and the outlets 8 and 10 can extend continually around the liquid filled space 2, forming a groove when viewed from the surface of the substrate. This groove can be annular, rectangular or polygonal. Alternatively the inlets and outlets can be provided at discrete locations in a continuous groove and not extend continuously around the length of the groove.

An additional horizontal member 16 connects the seal member 4 to the sides of a reference frame RF. This member provides support for the seal member in addition to the bearing and also ensures that the correct horizontal position is maintained. It keeps the seal member 4 substantially stationary with respect to the projection system PL in the horizontal, XY plane, but allows relative movement in the vertical, Z direction.

In use the outlet 8 is maintained at a lower pressure than the bearing liquid inlet 6 and therefore liquid will flow from the inlet 6 to the outlet 8. This creates a liquid seal to contain the liquid in the space 2. An additional benefit is that this flow of liquid radially inwards forms a hydrostatic bearing which can support the sealing member 4.

However, some liquid may "leak" radially outwards from the hydrostatic bearing into the rest of the apparatus. The vacuum system 10 removes this leaking water and also help to remove any liquid left adhering to the substrate W when the substrate W moves relative to the sealing member 4.

The flow of water into the space 2 via the inlet 12 is advantageously a very laminar flow (i.e. with a Reynolds number of much less than 2300). Likewise the flow of water through the outlet 8 is also preferably a laminar flow. This ensures that there is no turbulence in the liquid filling the space 2 and that there are no disturbances to the optical path through the liquid. The outlet 8 is responsible for removing the liquid from both the inlet 12 for the space and the inlet 6 for the bearing. Therefore, the cross-sectional area of the outlet 8 is larger than that of the inlet 12 to ensure that flow is laminar.

Passive springs 14 apply a biasing force to the seal member 4 in the direction of the substrate W. This biasing force allows the operating pressure of the hydrostatic bearing to be altered without needing to alter the dimensions of the bearing. The force exerted by the hydrostatic bearing must match the force exerted downwards due to gravity on the bearing and is equal to the pressure multiplied by the surface area over which the bearing acts. Therefore if a different operating pressure is desired either the effective area of the bearing must be changed or the force that the bearing supports must be changed. Although in this embodiment a spring 14 has been used to provide the biasing force, other means may also be appropriate, for example an electromagnetic force.

The height of the seal member 4 above the substrate W is adjustable between 10 and 500 µm according to the surface variations of the substrate W (and therefore the liquid flow) which must be accommodated. In this embodiment the gap is increased or decreased by altering the pressure of the hydrostatic bearing such that the seal member 4 moves relative to the substrate W. The pressure of the hydrostatic bearing is then returned to the equilibrium pressure when the correct position has been reached. An alternative method of varying the gap distance could make use of the springs 14. As the distance between the seal member 4 and the reference frame RF is varied the force exerted by the springs 14 will also vary. This means that the height of the seal member 4 above the substrate W can be adjusted by simply adjusting the operating pressure of the bearing.

A typical operating pressure of the hydrostatic bearing is between 100 Pa and 100 kPa overpressure relative to the environment. A preferable operating pressure is 3 kPa. Operation at this pressure allows the bearing to support the seal member 4 effectively and also provide some suspension. The bearing will have stiffness in the vertical direction and also for rotations about axes perpendicular to the vertical direction.

In this embodiment the same liquid is supplied to both the inlet 12 for the space and the inlet 6 for the bearing. This allows a common outlet 8 to be used without needing to consider the effects of mixing of two liquids, and possible diffusion from the liquid in the hydrostatic bearing into the liquid filled space 2. However, it need not be the same liquid and a different liquid can be supplied to the inlet 12 for the space and the inlet 6 for the bearing.

Although this embodiment has described providing the inlets and outlets on a surface of the seal member which faces the substrate, this does not have to be the case and other arrangements are possible.

While the use of a hydrostatic bearing has been described, a hydrodynamic bearing could also be used.

### Embodiment 2

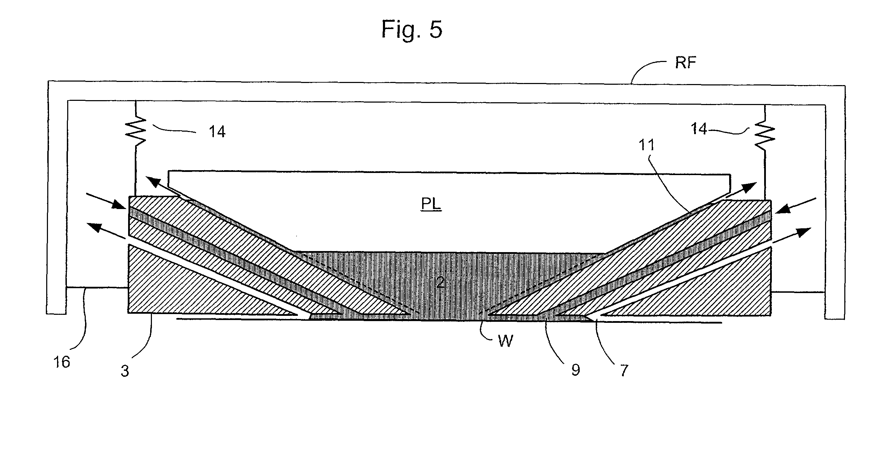

A cross section of a liquid supply system according to a second embodiment of the invention is shown in Figure 5. The construction of this embodiment is as for the first embodiment save as described below.

In this embodiment a seal member 3 has a single liquid inlet 9. The inlet 9 is located outwards in a radial direction with respect to the optical axis from a liquid filled space 2 between the final element of the projection system PL and the surface of the substrate W. Liquid supplied by the inlet 9 flows both inwards, into the space 2, and outwards towards an outlet 7. The outlet 7 is connected to a low pressure source. This causes the liquid to be sucked into the outlet 7 and prevented from entering the rest of the apparatus. A further outlet 11 is provided between the seal member 3 and the projection system PL to remove liquid from the space 2.

Preferably, the flow of liquid in the inlet 9 and outlet I 1 is a laminar flow to reduce turbulence. Turbulence in the liquid can have an adverse effect on the imaging process.

The construction of this embodiment is simplified over the above described first embodiment because only a single liquid inlet is required.

### Embodiment 3

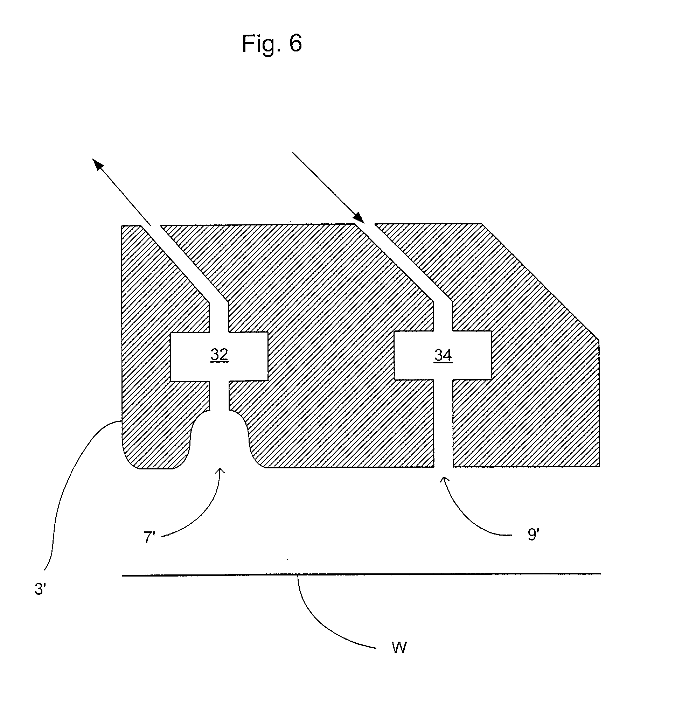

A cross section of a seal member according to a third embodiment of the present invention is shown in Figure 6. The construction of this embodiment is as for the second embodiment, save as described below.

A seal member 3' has a liquid inlet 9' and an outlet 7' which is connected to a low pressure source. The edges of the outlet 7' which face the surface of the substrate W are rounded, as is the edge of the seal member 3' adjacent to the outlet 7'. The rounded edges can have the form of an arc or an arbitrary curved profile. The degree of curvature depends on the dimensions of the inlet/outlet. In this embodiment the radius of curvature is preferably in the range 1 µm to 1mm. This improves the flow around the edge and reduces turbulence. By replacing the square edges with rounded edges in this manner, the flow of gas and/or liquid through the outlet 7' is improved.

To further improve the flow through the outlet 7', a duct or chamber 32 is provided within the seal member in the outlet 7'. This chamber 32 ensures that a homogenous low pressure source is provided.

A chamber 34 is also provided in the liquid inlet 9'. This ensures that an even, homogenous supply of liquid is achieved.

Figure 6 depicts the seal member 3' in cross section. It will be appreciated that the chambers 32 and 34 can extend continuously throughout the seal member or be located at discrete radial locations.

Although this embodiment has described both rounding the edges of the outlet 7' and providing chambers 32 and 34, either of these features could be provided independently of each other if desired. Likewise, the rounding and ducts of this embodiment may be applied to the seal member of the first embodiment described above, and to seal members having different configurations of inlets and outlets.

### Embodiment 4

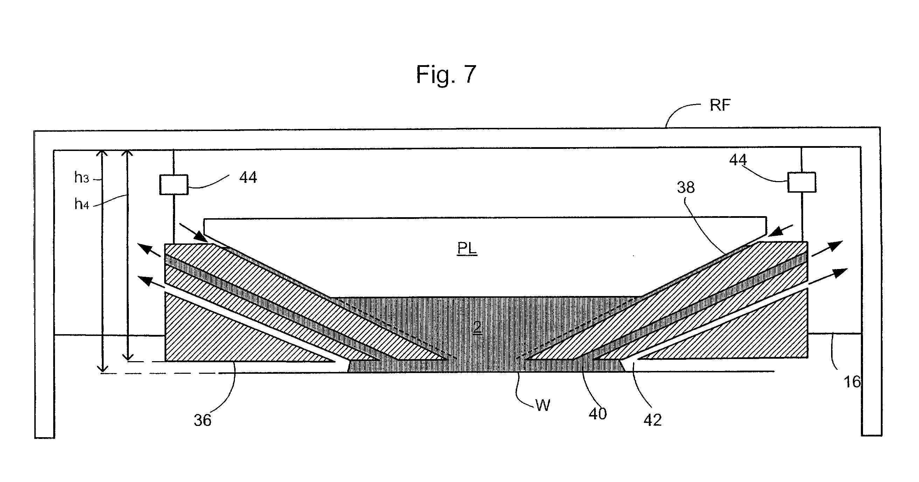

A cross section of a liquid supply system according to a fourth embodiment of the present invention is depicted in Figure 7. The construction of this embodiment is as for the first embodiment save as described below.

A seal member 36 delimits a space 2 between the projection system PL and the surface of the substrate W. Liquid is supplied to fill the space 2 formed between the final element of the projection system PL and the seal member 36 via an inlet 38. A liquid outlet 40 is formed in the surface of the seal member 36 which faces the substrate W (hereinafter referred to as the primary surface) and is located outwards in a radial direction from the optical axis of the projection system PL. This outlet 40 removes liquid from the space 2. Preferably, the flow of liquid in the inlet 38 and outlet 40 is a laminar flow. This avoids turbulence in the liquid filling the space 2 which can have an adverse effect on the imaging quality.

A further outlet 42 is formed in the primary surface of the seal member 36 outwards in a radial direction from the liquid outlet 40 and is connected to a low pressure source. This ensures that any liquid which is not removed by the liquid outlet 40 cannot "leak" into the remainder of the apparatus.

The seal member 36 is connected to a reference frame RF by a plurality of Lorentz actuators 44 (preferably three of which only two are shown in Figure 7). These actuators 44 are controlled by a controller to set the vertical position of the seal member 36 above the substrate W.

The controller takes an input of the distance h₃ between the surface of the substrate W and the reference frame RF and the distance, h₄, between the primary surface of the seal member 36 and the reference frame RF. These distances are measured by sensors (not shown). The controller can therefore calculate the height of the seal member 36 above the surface of the substrate W by subtracting h₄ from h₃. It then uses, for example, proportional, integral and derivative (PID) feedback control to control the actuators 44 so that the seal member is the correct height above the substrate. Other methods of control are also suitable.

The distance between the substrate and the seal member is adjustable up to 1 mm. The controller controls the seal member 36 with 3 degrees of freedom: displacement in the Z direction (parallel to the optical axis of the projection system PL) and rotations about axes perpendicular to the Z direction.

The seal member 36 is supported above the substrate W by the actuators 44. There is no need for a stiff connection between the substrate W and the seal member 36. This reduces the transmission of vibrations to the seal member 36 and simplifies the dynamics of the control of the substrate W in the Z direction.

Accordingly, the system of this embodiment can easily control the height of the seal member 36 above the surface of the substrate W to accommodate wide variations in the surface height of the substrate.

Although the use of Lorentz actuators 44 has been described other types of actuator are also suitable, for example pneumatic actuators.

It will be appreciated that the control system of this embodiment can be applied to the other embodiments described above.

### Embodiment 5

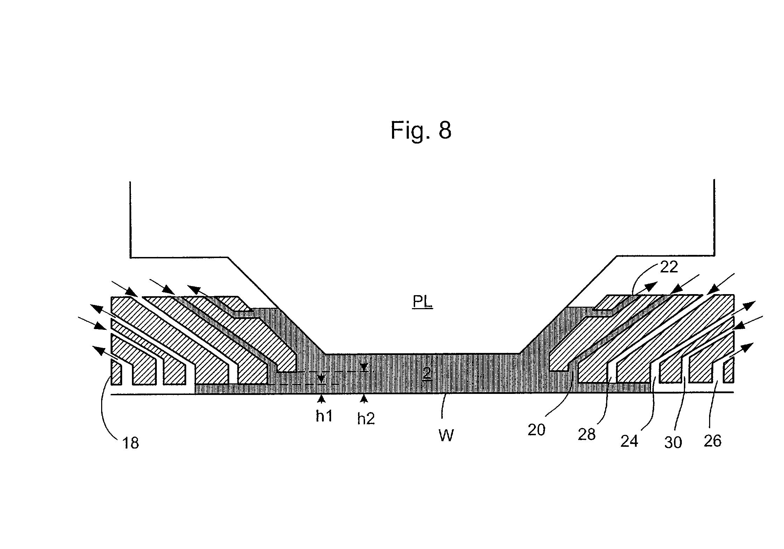

A liquid supply system according to a fifth embodiment of the invention is illustrated in Figure 8. The construction of this embodiment is as for the first embodiment, save as described below.

A seal member 18 surrounds the final element of the projection system PL to define a space 2 which is filled with a liquid. In this embodiment the liquid is primarily distilled water, although other liquids may also be used. Pressurized liquid is supplied to the space 2 by an inlet 20 formed on the surface of the seal member 18 which faces the substrate W (hereinafter referred to as the primary surface).

The liquid is removed at two locations. An upper outlet 22 removes liquid from near the top of the space 2. A lower outlet 24, formed in the primary surface of the seal member 4, removes liquid from the surface of the substrate W. Pressurized gas is supplied at two locations on the primary surface of the seal member 18 to ensure that the liquid remains in the space 2. A first gas inlet 28 is located radially inwards of the lower outlet 24 with respect to the optical axis of the projection system. It limits the flow of liquid to the lower outlet 24 by restricting the area available for the liquid to flow through to reach the lower outlet 24 and also decouples the pressure at inlet 20 from the pressure at lower outlet 24.

A low pressure or vacuum is maintained at the lower outlet 24 to suck liquid away as well as gas from the first gas inlet 28 and a second gas inlet 30. The flow of gas from the first gas inlet 28 to the lower outlet 24 enhances the liquid removal. The flow of gas from the second inlet 30 to lower outlet 24 is effective to create a gas seal. The gas supplied at the inlet 30 will also function to some extent as a gas bearing and help to support the seal member 18.

A low pressure or vacuum is also maintained at a third outlet 26, located radially outwards from the lower outlet 24 with respect to the optical axis of the projection system. The third outlet 26 acts to remove gas from second gas inlet 30 and to keep such gas from reaching the remainder of the apparatus.

Figure 8 depicts the seal member 18 in cross section. It will be appreciated that the inlets 20, 28 and 30 and the outlets 22, 24 and 26 can extend continually around the liquid filled space 2, forming a groove when viewed from the surface of the substrate. This groove can be annular, rectangular or polygonal. Alternatively, the groove can extend continually around the liquid filled space 2, but the inlets and outlets can only be present at discrete positions in the groove, not continuously along its length.

Liquid is supplied at the inlet 20 for two reasons. Firstly, it refreshes the liquid in the space 2 and allows the temperature and level of contaminants to be controlled. Secondly, it reduces gas inclusion. Gas inclusion can arise as the substrate W moves relative to the projections lens PL, agitating the liquid and transporting it away from the space 2. The pressure required to supply the liquid to meet these two criteria is calculated by two different formulas.

To avoid gas inclusion, the pressure required is:$\text{Δ} \text{p} \text{=} \frac{\text{6} \text{n} \text{νη}}{{\text{h}}_{\text{1}}}$

Where *n* is a safety factor of the order of 10, *v* is the scanning velocity, η is the viscosity of the liquid and h₁ is the height of the primary face of the seal member above the surface of the wafer between inlet 20 and outlet 28. For water, with typical values of *v*=0.5 m/s and *h*_{*1*}=30 µm the relative pressure required is approximately 1000 Pa, which is relatively low.

To refresh the liquid in the space 2, the pressure required is:$\text{Δ} \text{p} \text{=} \frac{{\text{6Φ}}_{\text{v,refresh}} {\text{d}}_{\text{1}} \text{η}}{\text{π} {\text{rh}}_{\text{2}} {\text{}}^{\text{3}}}$

Where Φ_{v.refresh} is the refreshment rate, h₂ is the height of the primary face of the seal member above the surface of the wafer between inlet 20 and the space 2 and d₁ is the distance between the liquid inlet 20 and the inner radial edge of the seal member 18. For water, with a typical Φ_{v.refresh}=1000 cm³/min, *r*=30 mm, *d*_{*1*}*=*3 mm and *h*_{*2*}=30 µm this gives a required relative pressure of approximately 100 kPa, which is high for practical applications. However, the inverse cube relationship to *h*_{*2*} means that if *h*_{*2*} can be increased by a factor of 4, the pressure is reduced by a factor of 64 resulting in an acceptable pressure of approximately 1.5 kPa. Other factors can be used to increase *h*_{*2*} as well, for example at least 1.5, preferably 2 or 3 and ideally at least 4 as described above.

Therefore, to reduce the pressure required to refresh the liquid, the height h₂ of the seal member 18 above the surface of the wafer W is 120 µm only in the region between the liquid filled space 2 and the liquid inlet 20. The height h₁ of the other parts of the seal member 18 above the surface of the substrate W is 30 µm.

As well as reducing the pressure required to refresh the liquid this construction also reduces the excess liquid flow generated by the movement of the substrate W. This excess liquid flow is removed at the lower outlet 24. Removing liquid by the low pressure or vacuum at the outlet 24 may cause unwanted mechanical vibrations. Reducing the volume of liquid removed at the outlet 24 therefore reduces the chance of unwanted mechanical vibrations being generated.

The removal of liquid at the outlet 24 can be improved by making the height of the primary surface of the seal member 18 above the surface of the substrate W greater between the first gas inlet 28 and the outlet 24 than between the liquid inlet 20 and the first gas inlet 28 (h₁).

It will be appreciated that the dimensions given in this embodiment can be adjusted depending on the operating liquid pressure desired, or on the viscosity of the liquid used to fill the space 2.

Whilst specific embodiments of the invention have been described above, it will be appreciated that the invention may be practiced otherwise than as described. The description is not intended to limit the invention.

## Claims

1. A lithographic projection apparatus comprising:
- a radiation system for providing a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate; and
- a liquid supply system for providing a space between a final element of said projection system and said substrate with a liquid,
**characterized in that** said liquid supply system comprises:
- a seal member extending along at least part of the boundary of said space between the final element of said projection system and said substrate; and
- a liquid seal means for forming a liquid seal between said seal member and the surface of the substrate.

2. Apparatus according to claim 1, wherein said liquid seal means is either a hydrostatic or a hydrodynamic bearing for at least partially supporting said seal member above the surface of said substrate.

3. Apparatus according to claim 1 or 2, wherein said seal member further comprises a shared liquid outlet for removing liquid from said space and from said liquid seal means.

4. Apparatus according to claim 3, wherein said shared outlet is located on a surface of said seal member which faces said substrate and is positioned between said space and said liquid seal means.

5. Apparatus according to claim 3 or 4, wherein said shared liquid outlet has a cross sectional area in a plane substantially parallel to said substrate which is greater than the cross sectional area of a liquid inlet.

6. A lithographic projection apparatus comprising:
- a radiation system for providing a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate; and
- a liquid supply system for providing a space between the final element of said projection system and said substrate with a liquid,
**characterized in that** said liquid supply system comprises:
- a seal member extending along at least part of the boundary of said space between the final element of said projection system and said substrate;
wherein said seal member comprises a liquid inlet located on a surface of said seal member which faces said substrate.

7. Apparatus according to claim 6, wherein the height of said seal member above the surface of said substrate is greater in the region between said space and said liquid inlet than elsewhere.

8. Apparatus according to claim 7, wherein said liquid supply system further comprises a gas seal means positioned outwards in a radial direction from said liquid inlet, for forming a gas seal between said seal member and the surface of said substrate.

9. Apparatus according to any one of claims 6 to 8, wherein said seal member further comprises an intermediate gas inlet and a liquid outlet respectively positioned outwards in a radial direction from said liquid inlet and both located on said surface of said seal member which faces said substrate.

10. Apparatus according to claim 9, wherein the height of said seal member above the surface of said substrate is greater between said intermediate gas inlet and said liquid outlet than between said liquid inlet and said intermediate gas inlet.

11. Apparatus according to claim 2, wherein the pressure of the liquid in said hydrostatic bearing is in the range of 100 Pa to 100 kPa relative to the ambient pressure.

12. Apparatus according to any one of the preceding claims, wherein said liquid supply system further comprises a low pressure source for preventing leakage of liquid in an outward radial direction, said low pressure source located on a surface of said seal member which faces said substrate.

13. Apparatus according to any one of the preceding claims, further comprising means for applying a biasing force directed towards the surface of said substrate to said seal member.

14. Apparatus according to any one of the preceding claims, further comprising a member connected between said seal member and a machine frame for supporting said seal member.

15. Apparatus according to any one of the preceding claims, wherein said seal member comprises at least one liquid inlet, at least one liquid outlet and at least one combined outlet for both liquid and gas.

16. Apparatus according to any one of the preceding claims, wherein said liquid supply system supplies liquid to said space at a rate of 0.1 to 10 liters per minute.

17. Apparatus according to any one of the preceding claims, wherein said liquid supply system supplies liquid to said space at a pressure which compensates for liquid transported away from said space by relative movement between said substrate and said seal member.

18. Apparatus according to any one of the preceding claims, further comprising at least one chamber formed upstream of an inlet and/or downstream of an outlet of said seal member.

19. Apparatus according to any one of the preceding claims, further comprising:
- at least one sensor to establish a distance between the surface of said substrate and said seal member; and
- a control system to control at least one actuator to maintain a desired distance between the surface of said substrate and said seal member based on the distance established by said sensor.

20. Apparatus according to any one of the preceding claims, wherein at least one inlet and/or outlet in said member has rounded edges.

21. Apparatus according to any one of the preceding claims, wherein at least one edge of said seal member adjacent to the surface of said substrate is rounded.
